# EUROPÄISCHE PATENTANMELDUNG

(11) **EP 4 687 291 A1**
(43) Veröffentlichungstag der Anmeldung: **04.02.2026**
(21) Anmeldenummer: 24192635.1
(22) Anmeldetag: 02.08.2024
(51) Int. Cl.: H03K 3/53, H05B 6/68, H05B 6/66

(54) **BETREIBEN EINES SYSTEMS ZUR GENERIERUNG ELEKTROMAGNETISCHER WELLEN IM MIKROWELLENBEREICH**

(71) Anmelder: Varian Medical Systems, Inc., Palo Alto, CA 94304 (US)
(72) Erfinder: Müller, Sven, 99198 Urbich (DE); Heuermann, Oliver, 91325 Adelsdorf (DE); Koschmieder, Martin, 07407 Uhlstädt-Kirchhasel (DE); Willing, Stefan, 07407 Rudolstadt (DE)
(74) Vertreter: Siemens Healthineers Patent Attorneys

(57) **Zusammenfassung**

Die Erfindung betrifft ein Verfahren zum Betreiben eines Systems zur Generierung elektromagnetischer Wellen im Mikrowellenbereich, wobei das System einen Impulsgenerator zur Generierung von elektrischen Pulsen, einen Mikrowellengenerator (14) zur Erzeugung von Mikrowellen und eine Übertragungsleitung (13) zwischen dem Impulsgenerator (10) und dem Mikrowellengenerator (14) umfasst, wobei das Verfahren umfasst: Blockieren einer Spannungsausgabe von dem Impulsgenerator (10) auf die Übertragungsleitung (13); nach dem Blockieren der Spannungsausgabe: Ausgeben einer Spannung von dem Impulsgenerator (10) auf die Übertragungsleitung (13), wobei die Spannung unterhalb einer Zündspannung des Mikrowellengenerators (14) liegt, zum Vorladen der Übertragungsleitung (13); nach dem Vorladen der Übertragungsleitung (13): Ausgeben einer Spannung auf die Übertragungsleitung (13), die oberhalb der Zündspannung des Mikrowellengenerators (14) liegt, sodass der Mikrowellengenerator (14) elektromagnetische Wellen im Mikrowellenbereich erzeugt.

## Beschreibung

Die Erfindung betrifft ein Verfahren zum Betreiben eines Systems zur Generierung elektromagnetischer Wellen im Mikrowellenbereich, eine Steuervorrichtung zum Ansteuern eines Impulsgenerators eines Systems zur Generierung elektromagnetischer Wellen im Mikrowellenbereich, ein System zur Generierung elektromagnetischer Wellen im Mikrowellenbereich und ein Therapie- und/oder Bildgebungsgerät.

Beispielsweise in der Bestrahlungstherapie wie auch in der zerstörungsfreien Werkstoffprüfung werden zur Erzeugung von elektromagnetischen Feldern im Mikrowellenbereich Laufzeitröhren, beispielsweise Magnetron oder Klystron, verwendet. Die Laufzeitröhren können insbesondere in einem Pulsbetrieb betrieben werden, um hohe Leistungen, insbesondere im Megawattbereich, zu realisieren. Dabei besteht eine Herausforderung darin, entsprechende Strompulse bzw. Spannungspulse von einem Impulsgenerator, insbesondere Modulator, zu einem Strahlkopf bzw. einer Strahlquelle zu übertragen. Insbesondere ist es oftmals erforderlich, den Impulsgenerator und den Strahlkopf räumlich getrennt aufzustellen, um beispielsweise einen Systemschwerpunkt anzupassen oder auch aus strahlenschutztechnischen Gründen (z.B. Schutz der Elektronik vor Neutronen). Die elektrischen Eigenschaften einer Laufzeitröhre können sich sprunghaft ändern, sobald eine angelegte Versorgungsspannung einen Schwellwert der Laufzeitröhre, der insbesondere als Zündspannung oder Durchbruchspannung bezeichnet werden kann, überschreitet. Bei einem gepulsten Betrieb tritt dieser Effekt entsprechend typischerweise bei jedem Spannungspuls auf. Dadurch kann es zu unerwünschten Schwankungen des Versorgungsstroms bzw. der Versorgungsspannung der Laufzeitröhre kommen.

Um dieses Problem anzugehen, gibt es im Stand der Technik den Ansatz einer Impedanzangepassten Leitungsübertragung. Die Impedanzanpassung kann insbesondere durch einen Transformator an der Strahlquelle erfolgen. Eine weitere Möglichkeit besteht in einer dynamischen Impedanzanpassung. Dabei können beispielsweise Modulatoren basierend auf Marx-Topologie (Marx-Generatoren) mit integrierten Anpasstransformatoren und unangepassten Leitungen verwendet werden. Diese Variante ist in DE 10 2011 086 551 A1 beschrieben.

Während die beschriebenen Lösungen grundsätzlich das Problem der unerwünschten Schwankungen lösen können, wäre es wünschenswert auch eine verbesserte Lösung zu finden. Eine verbesserte Lösung könnte mehr Möglichkeiten bei der Ausgestaltung entsprechender Systeme erlauben, insbesondere könnte flexibler auf Anforderungen wie verfügbarer Platz, zu verwendende Bauteile, etc. eingegangen werden. Beispielsweise sollte die verbesserte Lösung bevorzugt auch ohne impedanzgepasste, leitungsgebundene Hochspannungspulsübertragung und/oder ohne Anpasstransformator auskommen können.

Es ist daher eine Aufgabe der vorliegenden Erfindung, eine verbesserte Lösung zu finden, zur Übertragung von elektrischen Pulsen von einem Impulsgenerator bzw. Modulator zu einem Strahlkopf bzw. einer Strahlquelle. Weiterhin wäre es wünschenswert eine Lösung zu finden, mit der manche Bauteile, die gemäß Lösungen im Stand der Technik verwendet werden, nicht benötigt werden bzw. mit denen Bauraum und/oder Gewicht eingespart werden kann.

Diese Aufgabe wird gelöst durch ein Verfahren gemäß Anspruch 1, eine Steuervorrichtung gemäß Anspruch 8, ein System gemäß Anspruch 9, und ein Therapie- und/oder Bildgebungsgerät gemäß Anspruch 15. Weitere Merkmale und Vorteile ergeben sich aus den abhängigen Ansprüchen, der Beschreibung und den beigefügten Figuren.

Gemäß einem ersten Aspekt der Erfindung ist ein Verfahren zum Betreiben eines Systems zur Generierung elektromagnetischer Wellen im Mikrowellenbereich vorgesehen, wobei das System einen Impulsgenerator zur Generierung von elektrischen Pulsen, insbesondere von elektrischen Spannungspulsen und/oder elektrischen Strompulsen, einen Mikrowellengenerator zur Erzeugung von Mikrowellen und eine Übertragungsleitung zwischen dem Impulsgenerator und dem Mikrowellengenerator umfasst. Das Verfahren umfasst die folgenden Schritte:
- Blockieren einer Spannungsausgabe von dem Impulsgenerator auf die Übertragungsleitung;
- nach dem Blockieren der Spannungsausgabe: Ausgeben einer Spannung von dem Impulsgenerator auf die Übertragungsleitung, wobei die Spannung unterhalb einer Zündspannung des Mikrowellengenerators liegt, zum Vorladen der Übertragungsleitung;
- nach dem Vorladen der Übertragungsleitung: Ausgeben einer Spannung auf die Übertragungsleitung, die bei oder oberhalb der Zündspannung des Mikrowellengenerators liegt, insbesondere Erhöhen der Spannung auf die Spannung bei oder oberhalb der Zündspannung, sodass der Mikrowellengenerator elektromagnetische Wellen im Mikrowellenbereich erzeugt.

Vorteilhafterweise kann somit eine nicht-Impedanz-angepasste Übertragungsleitung verwendet werden um eine Spannungspulsübertragung, insbesondere Hochspannungspulsübertragung, zu dem Mikrowellengenerator zu realisieren. Es hat sich herausgestellt, dass durch das erfindungsgemäße Vorladen der Übertragungsleitung übermäßige Überschwingungen zu Beginn der elektrischen Pulse weitgehend verhindert werden können. Speziell kann eine Pulsübertragung ohne einen Anpasstransformator realisiert werden. Das heißt insbesondere, dass ein entsprechendes System derart ausgestaltet werden kann, dass sowohl der Impulsgenerator als auch die Übertragungsleitung bzw. die Übertragungskette der Pulse ohne Transformator, insbesondere ohne HV-Transformator, ausgestaltet werden kann. Daraus können Einsparungen beim benötigten Bauraum und dem Gewicht erzielt werden. Generell kann das Verfahren flexibel hinsichtlich der Länge der Übertragungsleitung sein, sodass beispielsweise Abstände zwischen Impulsgenerator und Mikrowellengenerator im Bereich von Metern als auch im Bereich von Zentimetern möglich sind. Es können mit diesem Verfahren auch entsprechende Pulsübertragungen über mehrere Meter, beispielsweise in der Größenordnung von bis zu 30 Metern ermöglicht werden. Das Verfahren kann Insbesondere ein Computer-implementiertes Verfahren sein. Mit anderen Worten können die Verfahrensschritte beispielsweise von einem Computer und/oder einer entsprechend programmierten Steuervorrichtung gesteuert werden.

Das für das Verfahren verwendete System umfasst einen Impulsgenerator zur Generierung von elektrischen Pulsen. Die Pulse können insbesondere elektrische Spannungspulse und/oder elektrische Strompulse sein. Der Impulsgenerator kann auch als Pulsgenerator bezeichnet werden. Generell kann der Impulsgenerator als eine Vorrichtung verstanden werden, die dazu ausgestaltet ist, elektrische Pulse zu erzeugen. Der Impulsgenerator kann ein Modulator zur Erzeugung und/oder zum Modulieren von elektrischen Pulsen, insbesondere Spannungspulsen und/oder Strompulsen sein. Der Impulsgenerator kann ohne HV-Transformator vorgesehen sein. HV steht dabei für Hochvolt. Hochvolt bezeichnet insbesondere Spannungen von über 30 Volt. Im Rahmen dieses Verfahrens können insbesondere Spannungen der übertragenen Spannungspulse im Kilovoltbereich vorgesehen sein. Der Impulsgenerator ist mit dem Mikrowellengenerator durch die Übertragungsleitung elektrisch verbunden.

Der Mikrowellengenerator ist generell eine Vorrichtung, die zur Erzeugung von Mikrowellen bzw. von elektromagnetischer Strahlung im Mikrowellenbereich ausgestaltet ist. Insbesondere ist der Mikrowellengenerator dazu ausgestaltet, basierend auf den elektrischen Pulsen die Mikrowellen zu erzeugen. Der Mikrowellengenerator kann insbesondere eine Laufzeitröhre sein. Unter einer Laufzeitröhre kann allgemein eine Elektronenröhre verstanden werden, die Mikrowellensignale bzw. Hochfrequenzsignale basierend auf der Laufzeit von Elektronen erzeugt oder verstärkt. Insbesondere kann der Mikrowellengenerator ein Magnetron oder ein Klystron sein. Vorzugsweise kann der Mikrowellengenerator dazu ausgestaltet sein, Mikrowellen mit einer Frequenz im Gigaherzbereich, insbesondere im Bereich von 1 Ghz bis 20 GHz, vorzugsweise im Bereich von 3 GHz bis 10 GHz zu erzeugen. Der Mikrowellengenerator kann auch als HF-Quelle (HF für Hochfrequenz) bezeichnet werden. Der Mikrowellengenerator kann Teil eines Strahlkopfes des Systems sein bzw. das System kann einen Strahlkopf umfassen, wobei der Strahlkopf den Mikrowellengenerator umfasst. Der Mikrowellengenerator weist eine Zündspannung auf. Die Zündspannung ist die Mindestspannung, ab der der Mikrowellengenerator seinen Betrieb aufnimmt, d.h. Mikrowellen erzeugt. Mit anderen Worten geht der Mikrowellengenerator bei bzw. oberhalb der Zündspannung in einen Betriebsmodus zur Erzeugung von Mikrowellen über. Unterhalb der Zündspannung erzeugt der Mikrowellengenerator entsprechend keine Mikrowellen bzw. jedenfalls keine wesentlichen Mengen an Mikrowellen. Insbesondere kann der Mikrowellengenerator unterhalb der Zündspannung in einem Bereitschaftsmodus sein, in dem der Mikrowellengenerator auf den nächsten elektrischen Puls wartet. Die Zündspannung kann auch als Durchbruchspannung des Mikrowellengenerators bezeichnet werden. Typischerweise leitet der Mikrowellengenerator unterhalb der Zündspannung im Wesentlichen keinen Strom bzw. bezieht im Wesentlichen keinen Strom.

Zur Übertragung der elektrischen Pulse ist die Übertragungsleitung zwischen dem Impulsgenerator und dem Mikrowellengenerator vorgesehen. Die Übertragungsleitung kann insbesondere ein Übertragungskabel bzw. Transmissionskabel sein. Insbesondere ist die Übertragungsleitung eine elektrische Leitung. Beispielsweise kann die Übertragungsleitung ein Koaxialkabel umfassen. Beispielsweise kann eine Länge der Übertragungsleitung im Bereich von Metern, insbesondere im Bereich von 10 bis 30 Metern, sein. Diese Länge der Übertragungsleitung kann vorteilhaft sein, weil somit eine räumliche Trennung von Impulsgenerator und Mikrowellengenerator möglich ist. Beispielsweise kann eine Elektronik des Impulsgenerators somit durch den räumlichen Abstand vor Neutronen geschützt werden, die in einem Strahlkopf des Systems erzeugt werden. Weiterhin kann eine entsprechend lange Übertragungsleitung eine räumliche Trennung der Komponenten ermöglichen, was insbesondere ermöglicht, dass Einzelteile des Systems weniger Gewicht aufweisen. Dadurch kann eine Installation, eine Wartung und/oder ein Austausch von Komponenten erleichtert werden. Optional ist jedoch auch eine kürzere Übertragungsleitung, beispielsweise mit einer Länge in der Größenordnung von Zentimetern, im Rahmen der Erfindung möglich.

Während des Verfahrens wird zunächst eine Spannungsausgabe von dem Impulsgenerator auf die Übertragungsleitung blockiert. Das Blockieren der Spannungsausgabe kann durch das Blockieren einer Leitungsverbindung vorgesehen sein. Das Blockieren und Ausgeben einer Spannung kann insbesondere im Rahmen eines gepulsten Betriebs zyklisch wiederholend vorgesehen sein. Mit anderen Worten kann es vorgesehen sein, dass die Verfahrensschritte mehrfach wiederholt werden.

Nach dem Blockieren der Spannungsausgabe wird eine Spannung von dem Impulsgenerator auf die Übertragungsleitung ausgegeben. Die Spannungsausgabe kann insbesondere auch mit einer Ausgabe eines elektrischen Stroms verknüpft sein. Die Spannung liegt dabei unterhalb der Zündspannung des Mikrowellengenerators. Beispielsweise kann ein Nennwert der Spannung bei 50 bis 95 %, bevorzugt, 70% bis 90%, besonders bevorzugt 75% bis 85%, der Zündspannung des Mikrowellengenerators liegen. Vorteilhafterweise kann mit der zunächst unterhalb der Zündspannung liegenden Spannung ein Vorladen der Übertragungsleitung initiiert werden. Ein sprunghaftes Einschalten der Spannung führt typischerweise zunächst zu einer Schwankung des in die Übertragungsleitung eingeführten Stroms, welcher damit insbesondere temporär bzw. zu Beginn auch auf höhere Werte ansteigen kann, als der eigentlich beabsichtigte Nennwert des Stroms. Vorteilhafterweise kann durch die unterhalb der Zündspannung gewählte Spannung jedoch verhindert werden, dass damit ein Strom des Mikrowellengenerators ebenfalls deutlich ansteigt. Insbesondere ist der Mikrowellengenerator unterhalb der Zündspannung typischerweise so hochohmig, dass kein wesentlicher Betriebsstrom durch den Mikrowellengenerator fließt. Vorteilhafterweise kann ein Strom des Mikrowellengenerators somit in einem im Wesentlichen nicht relevanten niedrigen Bereich gehalten werden.

Nach dem Vorladen der Übertragungsleitung wird eine Spannung auf die Übertragungsleitung ausgegeben, die bei bzw. oberhalb der Zündspannung des Mikrowellengenerators liegt. Der Begriff "oberhalb der Zündspannung" ist dabei breit zu verstehen. Insbesondere ist damit gemeint, dass die Spannung soweit erhöht wird, dass der Mikrowellengenerator in einen Betriebsmodus, in dem er Mikrowellen bzw. elektromagnetische Wellen im Mikrowellenbereich erzeugt, übergeht. Das Einstellen auf einen Spannungswert unterhalb der Zündspannung kann, insbesondere aufgrund des Vorladens, zu einem verzögerten tatsächlichen Spannungsanstieg während des Vorladens führen. Es kann vorgesehen sein, bei Erreichen eines Nennwerts der ausgegebenen Spannung das Erhöhen der Spannung über die Zündspannung zu initiieren. Das Erhöhen der Spannung auf über die Zündspannung kann insbesondere sprunghaft vorgesehen sein. "Sprunghaft" ist dabei im Rahmen der technischen Möglichkeiten der elektronischen Komponenten zu verstehen, d.h. eine gewisse technisch bedingte Verzögerung soll damit auch noch umfasst sein. Durch das Vorladen der Übertragungsleitung können Überschwingungen im Strom und der Spannung des Mikrowellengenerators auf ein deutlich geringeres Maß reduziert werden. Es erfolgt insbesondere ein zweistufiges, insbesondere dynamisches, Zuschalten der Spannung bzw. eines Spannungspulses. Es hat sich herausgestellt, dass ein Vorladen auf 70% bis 90%, insbesondere 75% bis 85%, der Zündspannung besonderes günstig ist, um Schwingungen zu vermeiden. Beispielsweise kann der Mikrowellengenerator bei einer Spannung von 40 kV operieren und die Spannung wird zunächst zum Vorladen auf 32 kV eingestellt, bevor sie dann auf 40 kV erhöht wird. Es kann vorgesehen sein, dass am Ende des Spannungspulses die ausgegebene Spannung des Impulsgenerators wieder blockiert wird. Das erneute Blockieren kann optional sprunghaft vorgesehen sein.

Gemäß einer Ausführungsform wird die Ausgabe der Spannung auf die Übertragungsleitung mit Hilfe eines einstellbaren Spannungsteilers gesteuert. Ein einstellbarer Spannungsteiler kann eine einfache Möglichkeit darstellen, um die Spannung auf die Übertragungsleitung einzustellen. Insbesondere kann mit dem Spannungsteiler die Spannung, die an dem Mikrowellengenerator anliegt, eingestellt werden. Beispielsweise kann der einstellbare Spannungsteiler einen einstellbaren ersten Teilwiderstand und einen zweiten Teilwiderstand umfassen, wobei einer der beiden Teilwiderstände an der Ausgabe des Impulsgenerators und der andere der beiden Teilwiderstände hinter dem einen der beiden Teilwiderstände und parallel zu dem Mikrowellengenerator geschaltet ist. In diesem Fall kann die Ausgabe der Spannung gesteuert werden, indem der einstellbare erste Teilwiderstand eingestellt wird.

Gemäß einer Ausführungsform umfasst der einstellbare Spannungsteiler einen einstellbaren ersten Teilwiderstand an der Ausgabe des Impulsgenerators und einen hinter den einstellbaren ersten Teilwiderstand und parallel zu dem Mikrowellengenerator geschalteten zweiten Teilwiderstand, wobei die Ausgabe der Spannung gesteuert wird, indem der einstellbare erste Teilwiderstand eingestellt wird. Der zweite Teilwiderstand kann optional vor der Übertragungsleitung geschaltet sein. Mit anderen Worten kann der zweite Teilwiderstand zwischen dem ersten Teilwiderstand und der Übertragungsleitung vorgesehen sein. Alternativ kann der zweite Teilwiderstand hinter der Übertragungsleitung geschaltet sein. Ist der zweite Teilwiderstand vor der Übertragungsleitung geschaltet, kann es optional vorgesehen sein, zumindest einen intrinsischen Widerstand des Impulsgenerators als zweiten Teilwiderstand zu verwenden. Der einstellbare Teilwiderstand kann somit als Schalter fungieren. Insbesondere kann der einstellbare Teilwiderstand auf einen sehr hohen Widerstandswert bzw. auf einen (quasi) unendlich hohen Widerstandswert eingestellt werden, um einen Spannungsausgabe zu blockieren. Ein sehr hoher Widerstandswert kann dabei vorzugsweise ein Widerstandswert sein, der Größer ist als der Widerstandswert des zweiten Teilwiderstands, insbesondere um eine Größenordnung oder mehr größer ist als der Widerstandswert des zweiten Teilwiderstands. Im Rahmen dieser Erfindung ist unter einer Größenordnung insbesondere eine Größenordnung im dezimalen Zahlensystem zu verstehen. Entsprechend bezeichnet eine Größenordnung einen Faktor von im Wesentlichen 10. Vorzugsweise ist der Widerstandswert des zweiten Teilwiderstandes größer, insbesondere um zumindest eine Größenordnung größer, als der Widerstand des Mikrowellengenerators im Betriebsmodus. Beispielsweise kann der zweite Teilwiderstand einen Widerstandswert im Kiloohmbereich (kΩ-Bereich), insbesondere im Bereich von 2 kΩ bis 20 kΩ, vorzugsweise im Bereich von 5 kΩ bis 15 kΩ, aufweisen. Ein Magnetron kann beispielsweise einen Widerstand im Betriebsmodus von 400 Ω aufweisen. In diesem Fall kann der zweite Teilwiderstand beispielsweise einen Widerstandswert von 10 kΩ aufweisen. Indem der Widerstandswert des zweiten Teilwiderstands größer, insbesondere um zumindest eine Größenordnung größer, ist als der Widerstand des Mikrowellengenerators kann sichergestellt werden, dass während des Betriebs des Mikrowellengenerators ein wesentlicher Teil des Stroms, insbesondere nahezu der gesamte Strom, durch den Mikrowellengenerator fließt. Der einstellbare Teilwiderstand kann eine Reihenschaltung von einstellbaren Widerständen umfassen. Vorteilhafterweise können somit die benötigten hohen Spannungen auch mit relativ einfachen Bauteilen kontrolliert werden.

Gemäß einer Ausführungsform wird der einstellbare erste Teilwiderstand zum Ausgeben der Spannung auf die Übertragungsleitung, die unterhalb der Zündspannung des Mikrowellengenerators liegt, auf einen ersten im Wesentlichen konstanten Widerstandswert eingestellt wird, wobei der einstellbare erste Teilwiderstand zum Ausgeben der Spannung auf die Übertragungsleitung, die bei oder oberhalb der Zündspannung des Mikrowellengenerators liegt, auf einen zweiten im Wesentlichen konstanten Widerstandswert eingestellt wird, wobei der zweite Widerstandswert geringer ist als der erste Widerstandswert. Insbesondere kann der zweite Widerstandswert um einen Faktor von zumindest 10, vorzugsweise zumindest 1.000, besonders bevorzugt zumindest 100000, geringer sein als der erste Widerstandswert. Mit anderen Worten kann somit durch Einstellen des Widerstandswert die ausgegebene Spannung kontrolliert werden, wobei mit einem niedrigeren Widerstand eine höhere Spannung ermöglicht werden kann. Besonders vorteilhaft ist dabei ein Faktor von zumindest 100000 (100k). Es hat sich herausgestellt, dass damit ein besonders gutes Verhindern von übermäßigen Ausschlägen des Stroms durch den Mikrowellengenerator erzielt werden kann.

Gemäß einer Ausführungsform liegt der erste Widerstandswert zwischen 10 Ohm und 100.000 Ohm, vorzugsweise zwischen 100 Ohm und 10.000 Ohm, besonders bevorzugt zwischen 500 Ohm und 5000 Ohm. Zusätzlich oder alternativ ist der zweite Widerstandswert geringer als 1 Ohm, vorzugsweise geringer als 0,1 Ohm besonders bevorzugt geringer als 0,01 Ohm. Insbesondere kann der zweite Widerstandswert so eingestellt werden, dass er effektiv nahezu Null ist.

Gemäß einer Ausführungsform umfasst der einstellbare erste Teilwiderstand zumindest einen Transistor, insbesondere zumindest einen Bipolartransistor und/oder zumindest einen MOS-FET (Metall-Oxid-Halbleiter-Feldeffekttransistor), und wobei der Widerstand durch Einstellen der Gate-Spannung des zumindest einen Transistors eingestellt wird. Es hat sich gezeigt, dass Transistoren, und insbesondere Bipolartransistoren oder MOS-FETs, besonders gut geeignet sind, um ein Umschalten und eine gezielte Spannungsteilung zu ermöglichen. Das Steuern der Gate-Spannung stellt dabei eine relativ einfache und gleichzeitig effektive Möglichkeit dar, einen Widerstand präzise einzustellen.

Gemäß einer Ausführungsform umfasst der einstellbare erste Teilwiderstand eine Reihenschaltung von hintereinandergeschalteten Transistoren, insbesondere Bipolartransistoren und/oder MOS-FETs. Insbesondere kann es vorgesehen sein, dass die hintereinandergeschalteten Transistoren simultan geschaltet werden, um eine ausgegebene Spannung einzustellen. Vorteilhafterweise können durch eine Reihenschaltung von Transistoren größere Spannungen kontrolliert werden, insbesondere ohne die Durchbruchspannung einzelner Transistoren zu überschreiben. Gerade bei größeren Spannungen, z.B. im Bereich von 40 kV, kann somit die Gesamtspannung auf mehrere Transistoren aufgeteilt werden, sodass die Last der einzelnen Transistoren geringer ist. Beispielsweise können 10 bis 200, vorzugsweise 40 bis 120, besonders bevorzugt 60 bis 100, Transistoren hintereinandergeschaltet sein. Es kann optional zusätzlich vorgesehen sein, Transistoren parallel zu schalten. Durch eine Parallelschaltung kann eine besser angepasste Spannungskontrolle ermöglicht werden. Beispielsweise können 2 bis 20, vorzugsweise 3 bis 8, Transistoren parallelgeschaltet sein. Gemäß einem speziellen Beispiel können vier parallele Reihen von jeweils hintereinandergeschalteten 80 Transistoren vorgesehen sein.

Gemäß einer Ausführungsform umfasst der Impulsgenerator zumindest einen Speicherkondensator zum Erzeugen der elektrischen Pulse. Der Speicherkondensator kann dazu vorgesehen sein, aufgeladen zu werden, insbesondere zyklisch mit den erzeugten Pulsen wiederholend aufgeladen zu werden, sodass Energie in dem Kondensator gespeichert wird, die für die jeweiligen Pulse freigesetzt wird.

Ein weiterer Aspekt der Erfindung ist eine Steuervorrichtung zum Ansteuern eines Impulsgenerators eines Systems zur Generierung elektromagnetischer Wellen im Mikrowellenbereich, wobei die Steuervorrichtung dazu ausgestaltet ist, das System Systems zur Generierung elektromagnetischer Wellen im Mikrowellenbereich, insbesondere wie hierin beschrieben, und/oder den Impulsgenerator, insbesondere wie hierin beschrieben, derart anzusteuern, dass ein Verfahren wie hierin beschrieben ausgeführt wird. Insbesondere kann die Steuervorrichtung dazu ausgestaltet sein, dass ein Verfahren wie hierin beschrieben automatisch ausgeführt werden kann bzw. wird. Alle Vorteile und Merkmale des Verfahrens können analog auf die Steuervorrichtung übertragen werden und umgekehrt. Die Steuervorrichtung kann beispielsweise einen Mikrokontroller umfassen. In dem Mikrocontroller kann ein Steuerprogramm implementiert sein, welches Befehle umfasst, das System bzw. den Impulsgenerator dazu zu veranlassen, ein Verfahren wie hierin beschrieben auszuführen. Die Steuervorrichtung kann jedoch auch anders ausgestaltet sein. Beispielsweise kann die Steuervorrichtung einen Computer umfassen oder Teil eines Computers sein und/oder die Steuervorrichtung kann Teil eines Kontrollsystems des Systems sein. Die Steuervorrichtung kann optional als Bestandteil des Systems, insbesondere Bestandteil des Impulsgenerators vorgesehen sein.

Ein weiterer Aspekt der Erfindung ist ein System zur Generierung elektromagnetischer Wellen im Mikrowellenbereich. Das System umfasst einen Impulsgenerator zur Generierung von elektrischen Pulsen, insbesondere elektrischen Spannungspulsen und/oder elektrischen Strompulsen, einen Mikrowellengenerator zur Erzeugung von Mikrowellen basierend auf den elektrischen Pulsen bei Überschreiten einer Zündspannung des Mikrowellengenerators, eine Übertragungsleitung, insbesondere Übertragungskabel, zwischen dem Impulsgenerator und dem Mikrowellengenerator zum Übertragen der elektrischen Pulse von dem Impulsgenerator zu dem Mikrowellengenerator und eine Steuervorrichtung wie hierin beschrieben. Alle Vorteile und Merkmale des Verfahrens und der Steuervorrichtung können analog auf das System übertragen werden und umgekehrt. Die Steuervorrichtung kann optional Bestandteil des Systems, insbesondere Bestandteil des Impulsgenerators, sein. Das System kann einen Strahlkopf umfassen, wobei der Strahlkopf insbesondere den Mikrowellengenerator und einen Teilchenbeschleuniger umfasst.

Gemäß einer Ausführungsform umfasst das System einen einstellbaren Spannungsteiler zum Steuern der Ausgabe der Spannung auf die Übertragungsleitung. Insbesondere kann das System eine elektrische Schaltung umfassen, die dazu ausgestaltet ist, mit Hilfe des einstellbaren Spannungsteilers eine Spannungsausgabe auf die Übertragungsleitung in einem Blockiermodus zu blockieren, in einem ersten Ausgabemodus auf eine Spannung unterhalb der Zündspannung und in einem zweiten Ausgabemodus auf eine Spannung bei oder oberhalb der Zündspannung einzustellen.

Gemäß einer Ausführungsform umfasst der einstellbare Spannungsteiler einen einstellbaren ersten Teilwiderstand an der Ausgabe des Impulsgenerators, der insbesondere Teil des Impulsgenerators ist, und einen hinter den einstellbaren ersten Teilwiderstand und parallel zu dem Mikrowellengenerator geschalteten zweiten Teilwiderstand, wobei die Steuervorrichtung dazu ausgestaltet ist, die Ausgabe der Spannung zu steuern, indem sie ein Einstellen des einstellbaren ersten Teilwiderstands veranlasst.

Gemäß einer Ausführungsform ist die Steuervorrichtung dazu ausgestaltet, den einstellbaren ersten Teilwiderstand zum Ausgeben der Spannung auf die Übertragungsleitung, die unterhalb der Zündspannung des Mikrowellengenerators liegt, auf einen ersten im Wesentlichen konstanten Widerstandswert einzustellen und den einstellbaren ersten Teilwiderstand zum Ausgeben der Spannung auf die Übertragungsleitung, die bei oder oberhalb der Zündspannung des Mikrowellengenerators liegt, auf einen zweiten im Wesentlichen konstanten Widerstandswert einzustellen, wobei der zweite Widerstandswert geringer ist als der erste Widerstandswert, insbesondere um einen Faktor von zumindest 10, vorzugsweise zumindest 1000, besonders bevorzugt zumindest 100000, geringer ist.

Gemäß einer Ausführungsform liegt der erste Widerstandswert zwischen 10 Ohm und 100.000 Ohm, vorzugsweise zwischen 100 Ohm und 10.000 Ohm, besonders bevorzugt zwischen 500 Ohm und 5000 Ohm, liegt. Zusätzlich oder alternativ ist der zweite Widerstandswert geringer als 1 Ohm, vorzugsweise geringer als 0,1 Ohm besonders bevorzugt geringer als 0,01 Ohm.

Gemäß einer Ausführungsform umfasst der einstellbare erste Teilwiderstand zumindest einen Transistor, insbesondere zumindest einen Bipolartransistor und/oder zumindest einen MOS-FET, wobei der Widerstand durch Einstellen der Gate-Spannung des zumindest einen Transistors, insbesondere durch die Steuervorrichtung, einstellbar ist.

Gemäß einer Ausführungsform umfasst der einstellbare erste Teilwiderstand eine Reihenschaltung von hintereinandergeschalteten Transistoren, insbesondere Bipolartransistoren und/oder MOS-FETs.

Gemäß einer Ausführungsform umfasst der Impulsgenerator zumindest einen Speicherkondensator zum Erzeugen der elektrischen Pulse.

Ein weiterer Aspekt der Erfindung ist ein Therapie- und/oder Bildgebungsgerät umfassend ein System zur Generierung elektromagnetischer Wellen im Mikrowellenbereich wie hierin beschrieben. Alle Vorteile und Merkmale des Verfahrens, der Steuervorrichtung und des Systems können analog auf das Therapie- und/oder Bildgebungsgerät übertragen werden und umgekehrt.

Alle hierin beschriebenen Ausführungsformen können miteinander kombiniert werden, soweit nicht explizit etwas anderes angegeben ist.

Im Folgenden werden Ausführungsformen mit Bezug auf die beigefügten Figuren beschrieben.
- Fig. 1: zeigt einen Schaltplan eines Systems zur Generierung elektromagnetischer Wellen im Mikrowellenbereich;
- Fig. 2: zeigt einen Widerstandsverlauf zum Erzeugen eines Pulses zur Generierung elektromagnetischer Wellen im Mikrowellenbereich nicht gemäß der Erfindung;
- Fig. 3: zeigt den Spannungs- und Stromverlauf während eines Verfahrens zum Betreiben eines Systems zur Generierung elektromagnetischer Wellen im Mikrowellenbereich nicht gemäß der Erfindung;
- Fig. 4: zeigt einen Schaltplan eines Systems zur Generierung elektromagnetischer Wellen im Mikrowellenbereich gemäß einer Ausführungsform der Erfindung;
- Fig. 5: zeigt einen Widerstandsverlauf zum Erzeugen eines Pulses zur Generierung elektromagnetischer Wellen im Mikrowellenbereich nach einem Verfahren gemäß einer Ausführungsform der Erfindung;
- Fig. 6: zeigt den Widerstands-, Spannungs- und Stromverlauf während eines Verfahrens zum Betreiben eines Systems zur Generierung elektromagnetischer Wellen im Mikrowellenbereich gemäß einer Ausführungsform der Erfindung; und
- Fig. 7: zeigt ein Therapie- und/oder Bildgebungsgerät gemäß einer Ausführungsform der Erfindung.

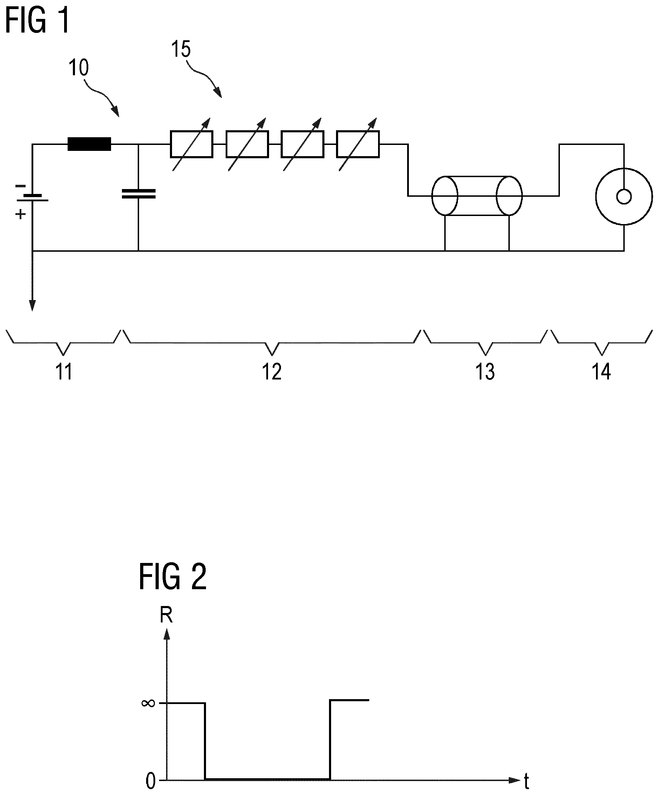

**Figur 1** zeigt einen Schaltplan eines Systems zur Generierung elektromagnetischer Wellen im Mikrowellenbereich. Das System umfasst einen Impulsgenerator 10, der als Direct-Switch-Modulator ausgebildet ist. Der Impulsgenerator 10 umfasst ein HV-Netzteil mit Filterdrossel 11 sowie einen Schalter 12 mit Speicherkondensator (hier als Direct-Switch) und ist dazu ausgestaltet, elektrische Pulse zu erzeugen, insbesondere Spannungspulse und Strompulse. Mittels einer Übertragungsleitung 13 werden die elektrischen Pulse zu einem Mikrowellengenerator 14, insbesondere einem Magnetron, übertragen. Beispielsweise kann die Übertragungsleitung 13 eine Länge von 10 bis 30 Metern aufweisen. Der Schalter 12 umfasst in diesem Beispiel eine Reihenschaltung 15 von Transistoren, wie beispielsweise Bipolartransistoren oder MOS-FETs.

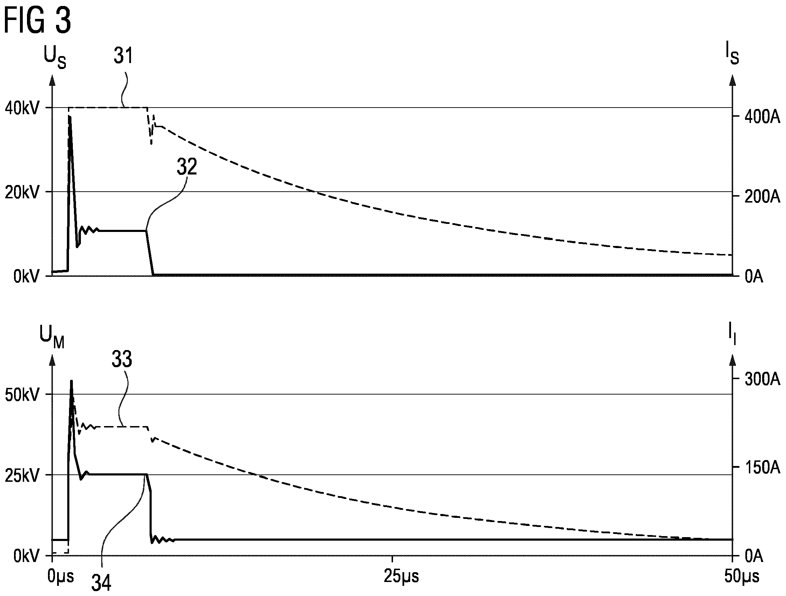

Die hier gezeigte Anzahl der Transistoren (4 Transistoren) ist nur als illustrativ anzusehen. Insbesondere kann eine andere Anzahl von Transistoren, beispielsweise auch eine deutlich größere Anzahl an Transistoren als gezeigt (zum Beispiel 40-100 Transistoren) vorgesehen sein. Die Transistoren werden über ihre Gate-Spannung kontrolliert, um eine Spannungsausgabe zu blockieren oder eine Spannung auszugeben. Durch das Kontrollieren der Gate-Spannung wird ein Gesamtwiderstand der Reihenschaltung eingestellt. Ein entsprechender Verlauf des Widerstandes ist in **Figur 2** zu sehen, wo der Widerstandsverlauf für einen Impuls gezeigt ist. Zunächst, wenn die Spannung blockiert werden soll, ist der Widerstand auf "unendlich" eingestellt. Abweichend von dieser Erfindung wird in diesem Beispiel von **Figur 2** der Widerstand danach direkt auf null herabgesetzt, sodass die ausgegebene Spannung über der Zündspannung des Mikrowellengenerators 14 liegt. Sowohl ein Widerstandswert von unendlich als ein Widerstandswert von null können hier als idealisierte Werte angesehen werden, d.h. in der Praxis kann der Widerstandswert auch auf nahezu oder quasi "unendlich" und nahezu oder quasi null eingestellt werden. Am Ende des elektrischen Pulses wird der Widerstandswert wieder auf "unendlich" eingestellt. Die resultierende ausgegebene Schaltungsspannung 31 (Us) und der zugehörige Schaltungsstrom 32 (I_{S}) sind in **Figur 3** oben gezeigt. Schaltungsspannung 31 und Schaltungsstrom 32 sind jeweils die Werte, die direkt am Ausgang des Impulsgenerators 10 ausgegeben werden bzw. dort gemessen werden können. Sobald der Widerstand auf null gestellt wird, erfolgt ein sprunghafter Anstieg der Schaltungsspannung 31 welche nach dem erneuten Schließen des Schalters bzw. dem Hochsetzen des Widerstandes auf "unendlich" wieder abfällt. Beim Verlauf des Schaltungsstroms 32 ist zu sehen, dass dieser sprunghaft ansteigt, sobald die Schaltungsspannung 31 aktiviert wird. Es ist dabei auch zu erkennen, dass der Schaltungsstrom 32 zunächst auf einen deutlich höheren Wert ansteigt und sich dann erst mit der Zeit auf seinen konstanten Wert einpendelt. Es kommt also zu Überschwingungen zu Beginn des ausgegebenen elektrischen Pulses. Unten in **Figur 3** ist der dazugehörige Magnetronstrom 34 und die Magnetronspannung 33 eines Magnetron, welches über die Übertragungsleitung 13 angeschlossen ist, gezeigt. Man erkennt, dass es auch hier zu deutlichen Überschwingungen zu Pulsbeginn kommt. Erst nach diesen Überschwingungen stabilisieren sich Magnetronstrom 34 und Magnetronspannung 33 allmählich auf einen konstanten Wert. Der Magnetronstrom 34 steigt kurz auf einen Wert von ca. 300 A an bevor er sich bei knapp über 120 A stabilisiert.

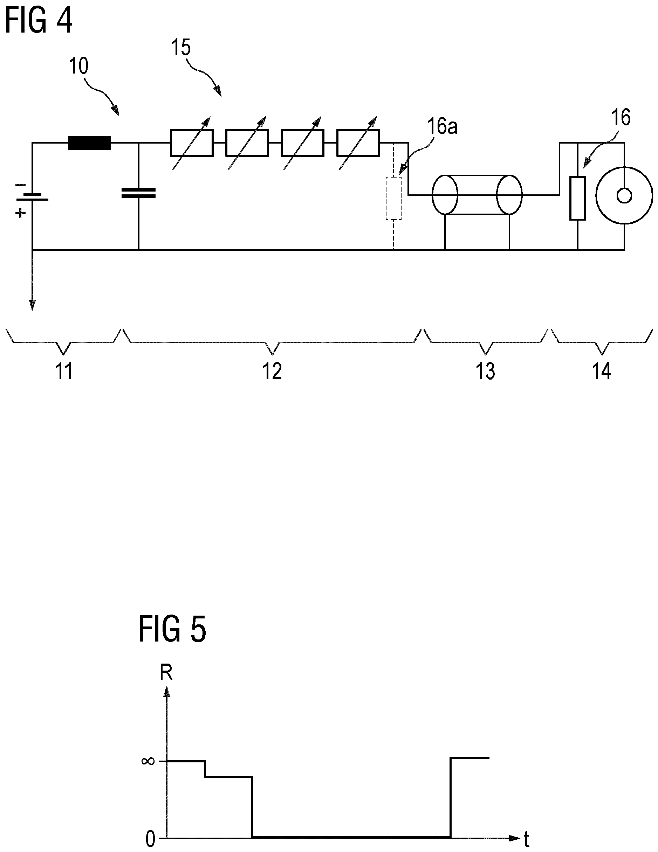

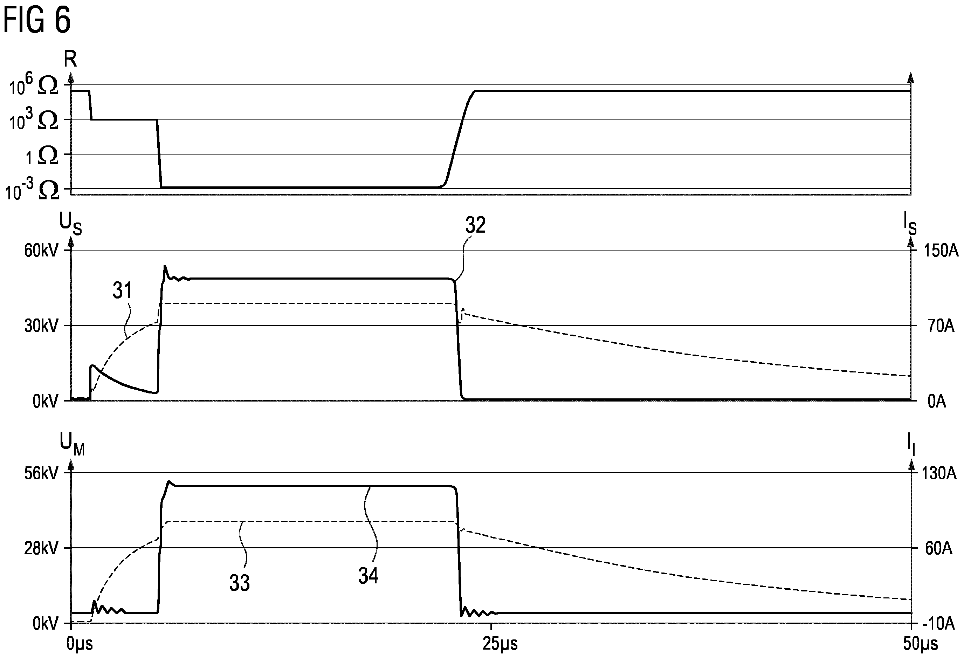

Wünschenswert wäre es hingegen dieses Überschwingungen des Magnetronstroms 34 und der Magnetronspannung 33 deutlich zu verringern. Dies kann erreicht werden, wenn erfindungsgemäß die ausgegebene Spannung zweistufig erhöht wird. Nämlich wird die Schaltungsspannung 31 zunächst auf eine Spannungswert unterhalb der Zündspannung des Mikrowellengenerators 14, in diesem Beispiel des Magnetrons, gestellt und dann auf eine Spannung oberhalb der Zündspannung erhöht. Dies kann beispielsweise durch einen Spanungsteiler mit einem einstellbaren Teilwiderstand gestehen, wie es in **Figur 4** gezeigt ist. **Figur 4** zeigt einen Schaltplan eines Systems zur Generierung elektromagnetischer Wellen im Mikrowellenbereich gemäß einer Ausführungsform der Erfindung. Hier bilden der Schalter 15 als erster Teilwiderstand zusammen mit einem zweiten Teilwiderstand 16 zusammen einen Spannungsteiler. Optional kann der zweite Teilwiderstand auch vor der Übertragungsleitung 13 angeordnet sein, was hier durch einen alternativen gestrichelten zweiten Teilwiderstand 16a angedeutet ist. Mit Hilfe des Spannungsteilers kann die Ausgabe der Spannung auf die Übertragungsleitung 13 kontrolliert werden. Der zweite Teilwiderstand 16 kann beispielsweise einen Widerstandswert von 10.000 Ohm aufweisen. Wie in der Ausführungsform von **Figur 1** umfasst der Schalter 12 in diesem Ausführungsbeispiel eine Reihenschaltung 15 von Transistoren. Ein Widerstand der Reihenschaltung 15 von Transistoren kann durch Kontrolle der Gate-Spannung der Transistoren eingestellt werden, die Reihenschaltung stellt also einen einstellbaren ersten Teilwiderstand dar. Die in **Figur 4** gezeigte Schaltung unterscheidet sich von derjenigen, die in **Figur 1** gezeigt ist, durch den zweiten Teilwiderstand 16. Die anderen Aspekte dieser Ausführungsform können grundsätzlich analog zu **Figur 1** ausgestaltet werden. Um nun eine zweistufige Einstellung der Spannung zu erzielen, werden die Transistoren der Reihenschaltung 15 für die Ausgabe eines elektrischen Pulses so kontrolliert, wie es in **Figur 5** gezeigt ist. Zu Beginn ist der Widerstand auf "unendlich" bzw. quasi "unendlich" eingestellt. Ein konkretes Beispiel für einen Verlauf des eingestellten Widerstandes ist in **Figur 6** oben gezeigt, wo der Widerstand logarithmisch aufgetragen ist. In diesem konkreten Beispiel bedeutet ein Widerstandswert von quasi "unendlich", dass der Widerstand auf ca. 500.000 Ohm eingestellt ist. Er liegt damit deutlich über einem Widerstandswert von 10.000 Ohm, der in diesem Beispiel für den zweiten Teilwiderstand 16 vorgesehen ist. Eine Spannungsausgabe von dem Impulsgenerator 10 auf die Übertragungsleitung 13 wird somit im Wesentlichen blockiert. Anschließend wird der Widerstand der Reihenschaltung 15 durch gleichmäßiges Kontrollieren der Gate-Spannung der Transistoren heruntergeregelt auf einen Widerstandswert von 1000 Ohm. Dieser Widerstand ist nun geringer als derjenige des zweiten Teilwiderstands 16 (10.000 Ohm). Entsprechend kommt es auch zu einem Spannungsanstieg der Schaltungsspannung 31 (siehe mittlerer Teil von **Figur 6**) und der Magnetronspannung 33 (siehe unterer Teil der **Figur 6**). Diese beiden Spannungen steigen im Wesentlichen gleichzeitig an bis sie eine Spannungswert von jeweils 32 kV erreicht haben. Dieser Spannungswert von 32 kV liegt unterhalb der Zündspannung des Magnetrons on 40kV. Es wird zwar zu Beginn ein Anstieg des Schaltungsstroms 32 als auch des Magnetronstroms 34 registriert, gerade der Anstieg des Magnetronstroms 34 ist jedoch verhältnismäßig gering. Der Strom kann im Wesentlichen über den zweiten Teilwiderstand 16 abfließen. Nach dem Erreichen der Spannung von 32 kV wird der Widerstandswert der Reihenschaltung 15 weiter verringert. Zu diesem Zeitpunkt bzw. kurz vor diesem Zeitpunkt ist die Übertragungsleitung 13 "vorgeladen" und es fließt noch ein relativ geringer Strom durch die Übertragungsleitung 13 von weniger als 10A. Sobald der Widerstandswert auf null gesetzt wird bzw. in diesem Beispiel auf 0.001 Ohm gesetzt wird, steigen die Schaltungsspannung 31 und die Magnetronspannung 33 quasi sprunghaft auf ca. 40 kV an. Dieser Spannungswert liegt oberhalb der Zündspannung des Magnetrons bzw. erreicht die Zündspannung des Magnetrons, wodurch nun auch der Magnetronstrom 34 sprunghaft ansteigt, in diesem Beispiel auf knapp über 120 A. Es ist gut erkennbar, dass es hierbei nur sehr geringfügig zu Überschwingungen des Magnetronstroms 34 kommt, insbesondere wenn man diesen Verlauf des Magnetronstroms 34 mit demjenigen aus **Figur 3** vergleicht. Der Magnetronstrom 34 überschreitet hier zu keinem Zeitpunkt einen Stromwert von 130 A. Vorteilhafterweise fließt zudem nahezu der gesamte Strom durch das Magnetron, weil der Widerstand des Magnetrons (ca. 400 Ohm) im Betriebsmodus deutlich geringer ist als der Widerstandswert des zweiten Teilwiderstandes 16. Mit anderen Worten ist der Magentonstrom 34 nur geringfügig niedriger als der Schaltungsstrom 32, welcher in diesem Beispiel bei knapp über 125 A liegt. Schließlich wird am Ende des elektrischen Pulses der Widerstand wieder auf "unendlich" bzw. auf 500.000 Ohm gesetzt. Somit fällt die Spannung 31, 33 wieder ab und der Strom 32, 34 wird wieder auf ca. 0 A reduziert, womit ein Puls abgeschlossen ist. Vorteilhafterweise können somit durch das zweistufige Einstellen der Spannung, in diesem Beispiel durch einen Spannungsteiler 16, Überschwingungen des Magentonstroms 34 zu einem wesentlichen Teil vermieden werden.

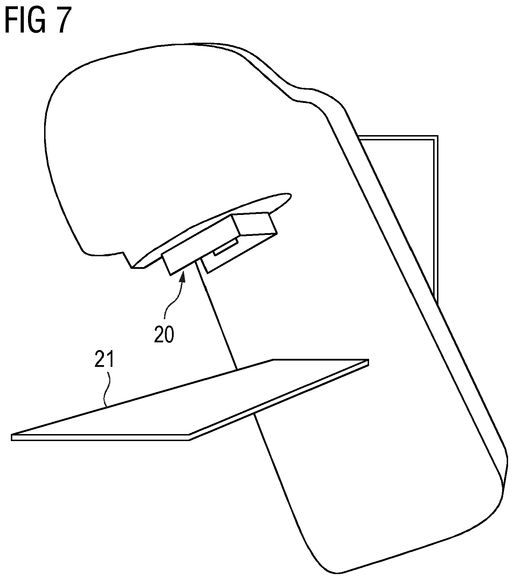

**Figur 7** zeigt ein Therapie- und/oder Bildgebungsgerät in Form eines medizinischen Linearbeschleunigers mit einem System zur Generierung elektromagnetischer Wellen im Mikrowellenbereich gemäß einer Ausführungsform der Erfindung. Insbesondere kann das Gerät ein System wie in Bezug auf **Figur 4** beschrieben umfassen. Mit dem Strahlkopf 20 können Elektronenstrahlen erzeugt bzw. beschleunigt werden, beispielsweise zur Untersuchung oder Therapie eines Patienten auf einer Patientenliege 21. Dabei können die Elektronen mit Hilfe von durch den Mikrowellengenerator 14 erzeugten Mikrowellenfeldern beschleunigt werden. Durch eine Steuervorrichtung (hier nicht gezeigt) kann ein Impulsgenerator 10 (siehe **Figur 4**) gesteuert werden, um ein erfindungsgemäßes Verfahren zum Betreiben des Systems auszuführen.

*Unabhängig vom grammatikalischen Geschlecht eines bestimmten Begriffes sind Personen mit männlicher, weiblicher oder anderer Geschlechteridentität mit umfasst.*

## Patentansprüche

1. Verfahren zum Betreiben eines Systems zur Generierung elektromagnetischer Wellen im Mikrowellenbereich, wobei das System einen Impulsgenerator zur Generierung von elektrischen Pulsen, einen Mikrowellengenerator (14) zur Erzeugung von Mikrowellen und eine Übertragungsleitung (13) zwischen dem Impulsgenerator (10) und dem Mikrowellengenerator (14) umfasst, wobei das Verfahren umfasst:
- Blockieren einer Spannungsausgabe von dem Impulsgenerator (10) auf die Übertragungsleitung (13);
- nach dem Blockieren der Spannungsausgabe: Ausgeben einer Spannung von dem Impulsgenerator (10) auf die Übertragungsleitung (13), wobei die Spannung unterhalb einer Zündspannung des Mikrowellengenerators (14) liegt, zum Vorladen der Übertragungsleitung (13);
- nach dem Vorladen der Übertragungsleitung (13): Ausgeben einer Spannung auf die Übertragungsleitung (13), die bei oder oberhalb der Zündspannung des Mikrowellengenerators (14) liegt, sodass der Mikrowellengenerator (14) elektromagnetische Wellen im Mikrowellenbereich erzeugt.

2. Verfahren gemäß Anspruch 1,
wobei die Ausgabe der Spannung auf die Übertragungsleitung (13) mit Hilfe eines einstellbaren Spannungsteilers gesteuert wird.

3. Verfahren gemäß Anspruch 2,
wobei der einstellbare Spannungsteiler einen einstellbaren ersten Teilwiderstand an der Ausgabe des Impulsgenerators (10), der insbesondere Teil des Impulsgenerators (10) ist, und einen hinter den einstellbaren ersten Teilwiderstand und parallel zu dem Mikrowellengenerator (14) geschalteten zweiten Teilwiderstand (16) umfasst,
wobei die Ausgabe der Spannung gesteuert wird, indem der einstellbare erste Teilwiderstand eingestellt wird.

4. Verfahren gemäß Anspruch 3,
wobei der einstellbare erste Teilwiderstand zum Ausgeben der Spannung auf die Übertragungsleitung (13), die unterhalb der Zündspannung des Mikrowellengenerators (14) liegt, auf einen ersten im Wesentlichen konstanten Widerstandswert eingestellt wird,
wobei der einstellbare erste Teilwiderstand zum Ausgeben der Spannung auf die Übertragungsleitung (13), die bei oder oberhalb der Zündspannung des Mikrowellengenerators (14) liegt, auf einen zweiten im Wesentlichen konstanten Widerstandswert eingestellt wird,
wobei der zweite Widerstandswert geringer ist als der erste Widerstandswert, insbesondere um einen Faktor von zumindest 10, vorzugsweise zumindest 1000, besonders bevorzugt zumindest 100000, geringer.

5. Verfahren gemäß Anspruch 4,
wobei der erste Widerstandswert zwischen 10 Ohm und 100.000 Ohm, vorzugsweise zwischen 100 Ohm und 10.000 Ohm, besonders bevorzugt zwischen 500 Ohm und 5000 Ohm, liegt und/oder
wobei der zweite Widerstandswert geringer ist als 1 Ohm, vorzugsweise geringer ist als 0,1 Ohm besonders bevorzugt geringer ist als 0,01 Ohm.

6. Verfahren gemäß einem der Ansprüche 3 bis 5,
wobei der einstellbare erste Teilwiderstand zumindest einen Transistor, insbesondere zumindest einen Bipolartransistor und/oder zumindest einen MOS-FET, umfasst und wobei der Widerstand durch Einstellen der Gate-Spannung des zumindest einen Transistors eingestellt wird.

7. Verfahren gemäß Anspruch 6,
wobei der einstellbare erste Teilwiderstand eine Reihenschaltung (15) von hintereinandergeschalteten Transistoren, insbesondere Bipolartransistoren und/oder MOS-FETs, umfasst.

8. Steuervorrichtung zum Ansteuern eines Impulsgenerators (10) eines Systems zur Generierung elektromagnetischer Wellen im Mikrowellenbereich,
wobei die Steuervorrichtung dazu ausgestaltet ist, das System und/oder den Impulsgenerator (10) derart anzusteuern, dass ein Verfahren gemäß einem der vorhergehenden Ansprüche ausgeführt wird.

9. System zur Generierung elektromagnetischer Wellen im Mikrowellenbereich umfassend
- einen Impulsgenerator (10) zur Generierung von elektrischen Pulsen;
- einen Mikrowellengenerator (14) zur Erzeugung von Mikrowellen basierend auf den elektrischen Pulsen bei Überschreiten einer Zündspannung des Mikrowellengenerators (14);
- eine Übertragungsleitung (13) zwischen dem Impulsgenerator (10) und dem Mikrowellengenerator (14) zum Übertragen der elektrischen Pulse von dem Impulsgenerator (10) zu dem Mikrowellengenerator (14); und
- eine Steuervorrichtung gemäß Anspruch 8.

10. System gemäß Anspruch 9,
wobei das System einen einstellbaren Spannungsteiler zum Steuern der Ausgabe der Spannung auf die Übertragungsleitung (13) umfasst.

11. System gemäß Anspruch 10,
wobei der einstellbare Spannungsteiler einen einstellbaren ersten Teilwiderstand an der Ausgabe des Impulsgenerators (10), der insbesondere Teil des Impulsgenerators (10) ist, und einen hinter den einstellbaren ersten Teilwiderstand und parallel zu dem Mikrowellengenerator (14) geschalteten zweiten Teilwiderstand umfasst,
wobei die Steuervorrichtung dazu ausgestaltet ist, die Ausgabe der Spannung zu steuern, indem sie ein Einstellen des einstellbaren ersten Teilwiderstands veranlasst.

12. System gemäß Anspruch 11,
wobei der einstellbare erste Teilwiderstand zumindest einen Transistor, insbesondere zumindest einen Bipolartransistor und/oder zumindest einen MOS-FET, umfasst und wobei der Widerstand durch Einstellen der Gate-Spannung des zumindest einen Transistors, insbesondere durch die Steuervorrichtung, einstellbar ist.

13. System gemäß Anspruch 12,
wobei der einstellbare erste Teilwiderstand eine Reihenschaltung (15) von hintereinandergeschalteten Transistoren, insbesondere Bipolartransistoren und/oder MOS-FETs, umfasst.

14. System gemäß einem der Ansprüche 9 bis 13,
wobei der Impulsgenerator (10) zumindest einen Speicherkondensator zum Erzeugen der elektrischen Pulse umfasst.

15. Therapie- und/oder Bildgebungsgerät umfassend ein System gemäß einem der Ansprüche 9 bis 14.
